# EUROPEAN PATENT APPLICATION

(11) **EP 4 489 531 A1**
(43) Date of publication of application: **08.01.2025**
(21) Application number: 23183049.8
(22) Date of filing: 03.07.2023
(51) Int. Cl.: H05K 3/00, H05K 3/28

(54) **A METHOD AND A SYSTEM FOR ENCAPSULATING A COMPONENT ARRANGED ON A SUBSTRATE**

(71) Applicant: GN Hearing A/S, 2750 Ballerup (DK)
(72) Inventor: Bodvarsson, Thorvaldur, 3500 Værløse (DK); Piotrowska, Kamila, Herlev (DK)
(74) Representative: GN Store Nord A/S

(57) **Abstract**

Disclosed is a method (100) of at least partly encapsulating at least one component (2) arranged on a substrate (4). The method (100) comprises the step of dispensing (110) at least one drop of a polymer (8) on and/or around the component (2) by jetting, using a nozzle (340), to obtain a dispensed polymer (8). The method (100) further comprises at least partly curing (130) the dispensed polymer (8) by exposing the dispensed polymer (8) to a light source (330) to obtain a cured polymer (8). The method (100) further comprises protecting (120) the nozzle (340) while at least partly curing (130) the dispensed polymer (8), and repeating (170) the steps of dispensing (110), at least partly curing (130) and protecting (120), thereby at least partly encapsulating the component (2).

## Description

### FIELD

The present invention relates to a method and a system of/for at least partly encapsulating a component arranged on a substrate. In addition, the disclosure relates to a hearing device comprising a substrate having at least one partly encapsulated component obtained according to said method.

### BACKGROUND

Electronic devices such as hearing devices typically comprise components which are sensitive to environmental factors, such as humidity, heat, cold, dust, sand, etc. Such components need to be protected from such environmental factors.

Electronic devices such as hearing devices typically also comprise components that emit a magnetic field, electric field or electromagnetic field. Such components needs to be shielded to protect other sensitive components and devices from the electric field, the magnetic field or the electromagnetic field emitted from such components that can otherwise interfere with the sensitive components and devices. Such components may also need to be shielded and protected from environmental interference.

Over the past years, different methods have been developed to provide such protection and/or such shielding. However, such methods have some drawbacks in terms of e.g. reliability and controllability. As an example top corners of components may be difficult to cover with a protecting material.

Therefore, there is a need for an improved method of as well as an improved system for at least partly encapsulating a component arranged on a substrate to provide said improved protection of such components in e.g. hearing devices against environmental factors and/or provide said improved shielding of such components in e.g. hearing devices to protect other sensitive components and/or the components themselves from emitted interference.

### SUMMARY

According to a first aspect, disclosed is a method of at least partly encapsulating at least one component arranged on a substrate. The method comprises the step of dispensing at least one first drop of a polymer on and/or around the component by jetting, using a nozzle, to obtain a dispensed polymer. The method further comprises the step of at least partly curing the dispensed polymer by exposing the dispensed polymer to a light source to obtain a cured polymer. The method further comprises the step of protecting the nozzle while at least partly curing the dispensed polymer. The method further comprises the step of repeating the steps of dispensing, protecting and at least partly curing, thereby at least partly encapsulating the at least one component.

The step of dispensing at least one first drop of the polymer on and/or around the component may comprise dispensing a drop of the polymer on and/or around the component. The step of dispensing at least one first drop of the polymer on and/or around the component may comprise dispensing a few drops, such as two or three or more drops, of the polymer on and/or around the component. The step of dispensing at least one first drop of the polymer on and/or around the component may comprise dispensing up to 10,000 drops of the polymer on and/or around the component. The step of dispensing may comprise dispensing all drops to be dispensed on the substrate.

The step of dispensing the at least one first drop of the polymer on and/or around the component by jetting, using the nozzle, to obtain the dispensed polymer allows for a controlled and reliable dispensing of the polymer on desired areas with a minimal of risk of applying the polymer on components and areas of the substrate which are not meant to be covered/encapsulated by the polymer. It further allows for dispensing the polymer around the component, i.e. on substrate areas around the component, e.g. between adjacent/naboring components, and thereby providing an efficient protection against adjacent/naboring components short circuiting each other. The step of dispensing the at least one first drop of the polymer on and/or around the component by jetting, using the nozzle, to obtain the dispensed polymer further allows for dispensing the polymer under the at least one component, e.g. into a free space between the component and the substrate, due to the jetting. Dispensing the polymer under the at least one component may provide protection underneath the component which is critical to obtain dirt and/or corrosion protection of the at least one component, i.e. to insure that there are no openings in the dispensed polymer covering the component wherethrough moisture and solid particles can reach the component and/or wherethrough a conductive material (added on top of the dispensed and/or at least partly cured polymer in order to provide shielding) may come into contact with terminals of the component. It is desired to prevent conductive material from coming into contact with terminals of the components as this may result in corrosion between the conductive material and the components resulting from a material thermodynamic mismatch between the material of respectivly the conductive material and the terminals of the components. Dispensing the polymer under the at least one component may further provide that a processing step of underfilling the at least one component when arranging/mounting the at least one component on the substrate may be skipped. The nozzle may be connected to a pump such that the polymer may be supplied from the pump into the nozzle. The step of dispensing may comprise jetting the at least one first drop of the polymer at a first frequency. The first frequency may be in the range of 1 Hz to 1000 Hz.

The step of dispensing may comprise jetting the at least one first drop of the polymer with a first interval. The step of dispensing by jetting may comprise periodically dispensing at least one drop of the polymer for a first period of time and not dispensing any polymer for a second period of time, i.e. having a break from dispensing during the second period of time. The first period of time may be in the range of 0.001 sec to 10 sec. The second period of time may be in the range of 0.001 sec to 10 sec.

The step of at least partly curing the dispensed polymer by exposing the dispensed polymer to the light source allows for obtaining the cured polymer. Thereby, the step of at least partly curing the dispensed polymer allows for preventing the cured polymer from moving, flowing or diffusing on and/or around the component or at least allows for mitigating the moving, flowing or diffusing of the cured polymer on and/or around the component. The step of at least partly curing the dispensed polymer may be performed subsequent to the step of dispensing the at least one drop of the polymer on and/or around the component. The at least partly curing the dispensed polymer by exposing the dispensed polymer to the light source causes changing at least a physical property of the dispensed polymer, e.g. changing a viscosity of the dispensed polymer. The step of at least partly curing the dispensed polymer may comprise partly curing the dispensed polymer. The partly curing of the dispensed polymer may comprise curing the dispensed polymer until a viscosity of at least a portion of the dispensed polymer changes. For example, the partly curing of the dispensed polymer may comprise curing the dispensed polymer until a surface of the dispensed polymer becomes hardened. The step of at least partly curing the dispensed polymer may comprise completely curing the dispensed polymer. The completely curing of the dispensed polymer may comprise curing the dispensed polymer until a viscosity of the entire dispensed polymer changes. For example, the completely curing of the dispensed polymer may comprise curing the dispensed polymer until the entire dispensed polymer becomes hardened.

The light source may be configured in a manner that the light source may emit light during the step of at least partly curing the dispensed polymer. In other words, the light source may not emit light during the step of dispensing the at least one drop of the polymer on and/or around the component. For instance, the step of at least partly curing the dispensed polymer may comprise exposing the dispensed polymer to the light source to obtain the at least partly cured polymer, wherein the light source may be turned on and off with a second interval. The second interval may be such that the light source is periodically on for a third period of time and off for a fourth period of time. The light source may be configured in a manner that the light source may emit light at a second frequency. The light source may alternately be activated/turned on and deactivated/turned off with the second frequency. The second frequency may be the same as the first frequency. The second frequency may be different from the first frequency. The second frequency may be in the range of 1 Hz to 1000 Hz.The second frequency may be configured such that the light source is on during the step of at least partly curing the dispensed polymer to expose the dispensed polymer to the light source, i.e. obtaining the cured polymer. The second frequency may be configured such that the light source is off during the step of dispensing the at least one first drop of the polymer on and/or around the component by jetting, using the nozzle, to obtain the dispensed polymer. The third period of time may be in the range of 0.001 sec to 10 sec. The fourth period of time may be in the range of 0.001 sec to 10 sec.

Alternatively, the step of at least partly curing the dispensed polymer may comprise exposing the dispensed polymer to the light source to obtain the at least partly cured polymer, wherein the light source has a light scheme. The light scheme may be such that it may not have a certain frequency but rather emit light when the nozzle is not dispensing the at least one first drop of the polymer on and/or around the component. For instance, the light scheme may emit light when the nozzle is not dispensing and is moving from one location to another location. For instance, the light scheme may emit light when the nozzle is moving from a first location corresponding to the location of the at least one component to a second location corresponding to a location of another component. The light source may be any light source suitable for at least partly curing the dispensed polymer.

The step of protecting the nozzle while at least partly curing the dispensed polymer allows for protecting polymer residues remained on and/or in the nozzle from becoming exposed to the light source during the step of at least partly curing the dispensed polymer. Thereby, a viscosity of the polymer residues remained on and/or in the nozzle may not change during the step of at least partly curing the dispensed polymer, as the nozzle is protected during the step of at least partly curing the dispensed polymer. In other words, the polymer residues remained on and/or in the nozzle may not become hardened during the step of at least partly curing the dispensed polymer, as the nozzle is protected during the step of at least partly curing the dispensed polymer. Thereby, the step of protecting the nozzle allows for providing a uniform dispense of the polymer on and/or around the component, i.e. dispensing the polymer having the same viscosity at all the times.

The step of repeating the steps of dispensing, protecting and at least partly curing, thereby at least partly encapsulating the at least one component allows for obtaining the at least partly encapsulated component. The at least partly encapsulating the at least one component allows for encapsulating at least a portion, a part, or a surface of a component, e.g. a top surface of a component. The at least partly encapsulating the at least one component allows for completely encapsulating a component i.e. completely encapsulating the entire (visible) surfaces of the component, such as a top surface, one or more side surfaces, one or more top corner(s) of the component and at least an edge part of the bottom surface of the component. The at least partly encapsulating the at least one component allows for at least partly encapsulating more components, e.g. at least partly encapsulating two or three components. For instance, it allows for encapsulating a portion, a part, or a surface of more components, e.g. top surfaces of more components. The at least partly encapsulating the at least one component also allows for completely encapsulating more components i.e. completely encapsulating the entire (visible) surfaces of all the components, such as the top surfaces, side surfaces, one or more top corner(s) of the component and at least an edge part of the bottom surfaces of more components. By the term "encapsulating the at least one component" is hereby meant protecting or enclosing the at least one component.

In overall, the method allows for an improved control on the encapsulation of the at least one component to protect the at least one component from damaging invironmental factors such as solid particles (like dirt and dust) and moisture, i.e. by preventing solid particles and moisture from reaching/damading/corroding the one or more components and/or by protect the at least one component from being short circuited by adjacent components and/or by protecting the terminals of the component to come into contact with conductive material. This is because the method allows for a controlled dispension of the polymer, e.g. a controlled drop by drop dispension of the polymer. Furthermore, the method allows for controlling a thickness of the dispensed polymer by controlling the amount of the polymer to be dispensed. This in turn allows for using less polymer material and hence allows for an economical-friendly method. In addition, controlling the thickness of the dispensed polymer by controlling the amount of the polymer to be dispensed further allows for a uniform and repeatable encapsulation of the component. The method further allows for a spatially controlled encapsulation of the at least one component by at least partly curing each dispensed polymer, subsequent to each step of dispensing. This is because the step of at least partly curing the dispensed polymer prevents the cured polymer from moving, flowing or diffusing on and/or around the component or at least mitigates the moving, flowing or diffusing of the cured polymer on and/or around the component. Thereby, the method allows for a full, consistent, reliable and controlled three-dimensional encapsulation of the at least one component. In addition, the method may be performed in a labor-free manner, e.g. in a programmed-controlled manner.

The substrate may be any substrate such as a printed circuit board (PCB) or a PCB assembly (PCBA). The substrate may be any conventional and commercially available substrate.

The at least one component may comprise any components containing metallic leads and/or terminals. The at least one component may be a component of a hearing device. The at least one component may comprise any electronic component, any magnetic component or any electromagnetic component. The electronic component may emit an electric (E) field i.e. be electrically noisy. The magnetic component may emit an magnetic (M) field i.e. be magnetically noisy. The electromagnetic component may emit an electromagnetic (EM) filed i.e. be electromagnetically noisy.

The one or more components of the hearing device may comprise different kinds of components. The one or more components of the hearing device may be one kind of components. The components of the hearing device may have different sizes and shapes, such as different heights, different base areas, different volumes etc.

In an embodiment, the hearing device is configured to be worn by a user. The hearing device may be arranged at the user's ear, on the user's ear, over the user's ear, in the user's ear, in the user's ear canal, behind the user's ear and/or in the user's concha, i.e. the hearing device is configured to be worn in, on, over and/or at the user's ear. The user may wear two hearing devices, one hearing device at each ear. The two hearing devices may be connected, such as wirelessly connected and/or connected by wires, such as a binaural hearing aid system.

The hearing device may be a hearable such as a headset, headphone, earphone, earbud, hearing aid, a personal sound amplification product (PSAP), an over-the-counter (OTC) hearing device, a hearing protection device, a one-size-fits-all hearing device, a custom hearing device or another head-wearable hearing device. Hearing devices can include both prescription devices and non-prescription devices.

The hearing device may be embodied in various housing styles or form factors. Some of these form factors are Behind-the-Ear (BTE) hearing device, Receiver-in-Canal (RIC) hearing device, Receiver-in-Ear (RIE) hearing device or Microphone-and-Receiver-in-Ear (MaRIE) hearing device. These devices may comprise a BTE unit configured to be worn behind the ear of the user and an in the ear (ITE) unit configured to be inserted partly or completely into the user's ear canal. Generally, the BTE unit may comprise at least one input transducer, a power source and a processing unit. The term BTE hearing device refers to a hearing device where the receiver, i.e. the output transducer, is comprised in the BTE unit and sound is guided to the ITE unit via a sound tube connecting the BTE and ITE units, whereas the terms RIE, RIC and MaRIE hearing devices refer to hearing devices where the receiver may be comprise in the ITE unit, which is coupled to the BTE unit via a connector cable or wire configured for transferring electric signals between the BTE and ITE units.

Some of these form factors are In-the-Ear (ITE) hearing device, Completely-in-Canal (CIC) hearing device or Invisible-in-Canal (IIC) hearing device. These hearing devices may comprise an ITE unit, wherein the ITE unit may comprise at least one input transducer, a power source, a processing unit and an output transducer. These form factors may be custom devices, meaning that the ITE unit may comprise a housing having a shell made from a hard material, such as a hard polymer or metal, or a soft material such as a rubber-like polymer, molded to have an outer shape conforming to the shape of the specific user's ear canal.

Some of these form factors are earbuds, on the ear headphones or over the ear headphones. The person skilled in the art is well aware of different kinds of hearing devices and of different options for arranging the hearing device in, on, over and/or at the ear of the hearing device wearer. The hearing device (or pair of hearing devices) may be custom fitted, standard fitted, open fitted and/or occlusive fitted.

In an embodiment, the hearing device may comprise one or more input transducers. The one or more input transducers may comprise one or more microphones. The one or more input transducers may comprise one or more vibration sensors configured for detecting bone vibration. The one or more input transducer(s) may be configured for converting an acoustic signal into a first electric input signal. The first electric input signal may be an analogue signal. The first electric input signal may be a digital signal. The one or more input transducer(s) may be coupled to one or more analogue-to-digital converter(s) configured for converting the analogue first input signal into a digital first input signal.

In an embodiment, the hearing device may comprise one or more antenna(s) configured for wireless communication. The one or more antenna(s) may comprise an electric antenna. The electric antenna may be configured for wireless communication at a first frequency. The first frequency may be above 800 MHz, preferably a wavelength between 900 MHz and 6 GHz. The first frequency may be 902 MHz to 928 MHz. The first frequency may be 2.4 to 2.5 GHz. The first frequency may be 5.725 GHz to 5.875 GHz. The one or more antenna(s) may comprise a magnetic antenna. The magnetic antenna may comprise a magnetic core. The magnetic antenna may comprise a coil. The coil may be coiled around the magnetic core. The magnetic antenna may be configured for wireless communication at a second frequency. The second frequency may be below 100 MHz. The second frequency may be between 9 MHz and 15 MHz.

In an embodiment, the hearing device may comprise one or more wireless communication unit(s). The one or more wireless communication unit(s) may comprise one or more wireless receiver(s), one or more wireless transmitter(s), one or more transmitter-receiver pair(s) and/or one or more transceiver(s). At least one of the one or more wireless communication unit(s) may be coupled to the one or more antenna(s). The wireless communication unit may be configured for converting a wireless signal received by at least one of the one or more antenna(s) into a second electric input signal. The hearing device may be configured for wired/wireless audio communication, e.g. enabling the user to listen to media, such as music or radio and/or enabling the user to perform phone calls.

In an embodiment, the wireless signal may originate from one or more external source(s) and/or external devices, such as spouse microphone device(s), wireless audio transmitter(s), smart computer(s) and/or distributed microphone array(s) associated with a wireless transmitter. The wireless input signal(s) may origin from another hearing device, e.g. as part of a binaural hearing system and/or from one or more accessory device(s), such as a smartphone and/or a smart watch.

In an embodiment, the hearing device may include a processing unit. The processing unit may be configured for processing the first and/or second electric input signal(s). The processing may comprise compensating for a hearing loss of the user i.e. apply frequency dependent gain to input signals in accordance with the user's frequency dependent hearing impairment. The processing may comprise performing feedback cancelation, beamforming, tinnitus reduction/masking, noise reduction, noise cancellation, speech recognition, bass adjustment, treble adjustment and/or processing of user input. The processing unit may be a processor, an integrated circuit, an application, functional module, etc. The processing unit may be implemented in a signal-processing chip or a printed circuit board (PCB). The processing unit may be configured to provide a first electric output signal based on the processing of the first and/or second electric input signal(s). The processing unit may be configured to provide a second electric output signal. The second electric output signal may be based on the processing of the first and/or second electric input signal(s).

In an embodiment, the hearing device may comprise an output transducer. The output transducer may be coupled to the processing unit. The output transducer may be a receiver. It is noted that in this context, a receiver may be a loudspeaker, whereas a wireless receiver may be a device configured for processing a wireless signal. The receiver may be configured for converting the first electric output signal into an acoustic output signal. The output transducer may be coupled to the processing unit via the magnetic antenna. The output transducer may be comprised in an ITE unit or in an earpiece, e.g. Receiver-in-Ear (RIE) unit or Microphone-and-Receiver-in-Ear (MaRIE) unit, of the hearing device. One or more of the input transducer(s) may be comprised in an ITE unit or in an earpiece.

In an embodiment, the wireless communication unit may be configured for converting the second electric output signal into a wireless output signal. The wireless output signal may comprise synchronization data. The wireless communication unit may be configured for transmitting the wireless output signal via at least one of the one or more antennas.

In an embodiment, the hearing device may comprise a digital-to-analogue converter configured to convert the first electric output signal, the second electric output signal and/or the wireless output signal into an analogue signal.

In an embodiment, the hearing device may comprise a vent. A vent is a physical passageway such as a canal or tube primarily placed to offer pressure equalization across a housing placed in the ear such as an ITE hearing device, an ITE unit of a BTE hearing device, a CIC hearing device, a RIE hearing device, a RIC hearing device, a MaRIE hearing device or a dome tip/earmold. The vent may be a pressure vent with a small cross section area, which is preferably acoustically sealed. The vent may be an acoustic vent configured for occlusion cancellation. The vent may be an active vent enabling opening or closing of the vent during use of the hearing device. The active vent may comprise a valve.

In an embodiment, the hearing device may comprise a power source. The power source may comprise a battery providing a first voltage. The battery may be a rechargeable battery. The battery may be a replaceable battery. The power source may comprise a power management unit. The power management unit may be configured to convert the first voltage into a second voltage. The power source may comprise a charging coil. The charging coil may be provided by the magnetic antenna.

In an embodiment, the hearing device may comprise a memory, including volatile and nonvolatile forms of memory.

In some embodiments, the step of dispensing comprises dispensing the at least one first drop of the polymer on and/or around at least a side of the component. The at least one first drop of the polymer may be dispensed on at least a side of the component and/or around at least a side of the component, e.g. on/around corners/edges of the sides of the component and/or between corners/edges of the sides of the component and the substrate. Thereby, the method not only allows for dispensing the polymer on and/or around the component but also the method may allow for dispensing the polymer on sides of the component. Hence, the method may allow a uniform, full, complete, consistent, reliable and controlled three-dimensional encapsulation of the at least one component on the substrate.

In some embodiments, the step of dispensing comprises jetting the at least one first drop of a UV-curable polymer on and/or around and/or under the component. This may allow for obtaining a dispensed UV-curable polymer on and/or around and/or under the component. The UV-curable polymer may be any conventional and commercially available UV-curable polymer. The polymer may comprise acrylated (poly)urethane, for example Humiseal UV40 polymer.

In some embodiments, the step of at least partly curing comprises at least partly curing the dispensed polymer by exposing the dispensed polymer to a UV light source to obtain a cured polymer. In other words, the step of at least partly curing comprises at least partly curing the dispensed UV-curable polymer by exposing the dispensed UV-curable polymer to the UV light source to obtain the cured polymer. The at least partly curing the dispensed UV-curable polymer by exposing the dispensed UV-curable polymer to the UV light source may cause changing at least a physical property of the dispensed UV-curable polymer, e.g. changing a viscosity of the dispensed UV-curable polymer. The UV light source may have a wavelength in the range of 100 nm to 400 nm. The UV light source may provide UVA and/or UVB and/or UVC light/rays.

In some embodiments, the step of at least partly curing comprises exposing the dispensed polymer to the UV light source until a surface of the dispensed polymer becomes at least partly cured. In other words, the step at least partly curing may comprise exposing the dispensed UV-curable polymer to the UV light source until the surface of the dispensed UV-curable polymer becomes at least partly cured. Thereby, the surface of the dispensed UV-curable polymer may become hardened. Hence, the dispensed UV-curable polymer may not move, flow, or diffuse on and/or around the component, subsequent to the step of at least partly curing. This may in turn allow for spatially controlling encapsulation of the at least one component and hence may allow for providing a full, complete, consistent, reliable and controlled three-dimensional encapsulation of the at least one component.

In some embodiments, the step of dispensing comprises jetting the at least one first drop of the polymer at a first frequency in the range of 1 Hz to 1000 Hz. The first frequency may depend on several factors such as nozzle size, material viscosity of the dispensed polymer, etc. The step of dispensing at the first frequency in the range of 1 Hz to 1000 Hz may result into dispension of 100 to 1000 drops of the polymer per second. Hence, the step at dispensing at the frequency in the range of 1 Hz to 1000 Hz may result into at least partly encapsulating the at least one component in a time-efficient manner.

In some embodiments, the step of protecting comprises protecting the nozzle from light by means of a protection element while at least partly curing the dispensed polymer. Thereby, the protection element may protect the nozzle and the polymer residues remained in and/or on the nozzle from becoming exposed to the light source in an improved manner. The protection element may comprise an opening aligned with a tip/opening of the nozzle wherethrough the polymer is dispensed. The protection element may further comprise a protection mechanism allowing for an efficient and fast opening/closing of the opening of the protection element. The protection mechanism may be an electrically and/or automatically controlled protection mechanism. The protection element may comprise a shutter. The shutter may comprise one or more movable shutter plates. The protection element may further comprise a shield surrounding the nozzle, such as surrounding sides of the nozzle. The opening of the protection element may be comprised in the shield as an opening in the shield. The opening in the shield may be aligned with the tip/opening of the nozzle wherethrough the polymer is dispensed. The protection mechanism, such as the one or more shutter plates, may be configured to cover the opening in the protection element, such as the shield surrounding the sides of the nozzle.

In some embodiments, the method further comprises loading the polymer into the nozzle for at least a second drop of the polymer while at least partly curing the dispensed polymer and/or after dispensing the at least one first drop of the polymer and/or while/during/at the same time as dispensing the at least one first drop of the polymer. Thereby, the loading of the polymer into the nozzle may provide the polymer material for at least the second drop of the polymer, i.e. for a next step of dispensing and/or a next cycle of the steps dispensing, protecting and at least partly curing. Hence, the loading of the polymer into the nozzle may allow for the step of repeating and hence may allow for at least partly encapsulating the component. The loading of the polymer into the nozzle may also allow for providing a more time-efficient method, as the nozzle becomes loaded during the step of at least partly curing the dispensed polymer, i.e. during the break time of the step of dispensing. The nozzle may be connected to a first container. The first container may be a pump, e.g. a stroke or a piezo-electric pump. The first container may be a syringe. The first container may be connected to a second container. The second container may also be a pump, e.g. a stroke or a piezo-electric pump. The second container may be a cartridge. The polymer material may be loaded to the second container. The first container may be arranged downstream the second container such that the polymer material may flow from the second container into the first container. The nozzle may be arranged downstream the first container such that the polymer material may flow from the first container into the nozzle for a next step of dispensing.

The step of loading the polymer into the nozzle may be performed at the same time as the step of protecting the nozzle. The step of loading the polymer into the nozzle may be performed prior to the step of protecting the nozzle. The step of loading the polymer into the nozzle may be performed subsequent to the step of protecting the nozzle.

The step of loading the polymer into the nozzle may be performed prior to the step of dispensing one drop of polymer, such as the first or second drop of polymer. The step of loading the polymer into the nozzle may be performed subsequent to the step of dispensing one drop of polymer, such as the first or second drop of polymer. The step of loading the polymer into the nozzle may be performed at the same time as the step of dispensing one drop of polymer, such as the first or second drop of polymer.

The step of loading the polymer into the nozzle may be performed at the same time as the step of at least partly curing. The step of loading the polymer into the nozzle may be performed prior to the step of at least partly curing. The step of loading the polymer into the nozzle may be performed subsequent to the step of at least partly curing.

In some embodiments, the method further comprises completely curing the at least partly encapsulated component subsequent to the step of repeating the steps of dispensing, at least partly curing and protecting, when the at least one component is at least partly encapsulated. Thereby, the partly encapsulated component may be completely cured at once. This may in turn allow for an even more improved method by providing a more controlled, reliable, consistent and uniform encapsulation of the component. This is since the completely curing of the at least partly encapsulated component prevents or at least mitigate over-curing those dispensed and cured drops of the polymer which were dispensed earlier in the method, as all the dispensed and cured drops of the polymer may be completely cured all at once. In addition, the completely curing of the at least partly encapsulated component may allow for an even more time-efficient method. The completely curing of the at least partly encapsulated component may be performed using the same light source used for at least partly curing the dispensed polymer. The completely curing of the at least partly encapsulated component may be performed using another light source than the one used for at least partly curing the dispensed polymer, e.g. the substrate with the at least partly encapsulated component may be moved to another station of the system (for at least partly encapsulating a component arranged on a substrate) with another light source, which makes it possible to start on at least partly encapsulating one or more components on another substrate at the first station while completely curring the substrate with the at least partly encapsulated component.

The system (for at least partly encapsulating a component arranged on a substrate) may further comprise a conveyor belt. The conveyor belt may be configured to transport the substrate to the another station, e.g. a station to completely cure the at least partly encapsulated component. The system may further comprise another light source. The another light source may be configured to completely cure the at least partly encapsulated component. The another light source may be of the same type as the light source used for at least partly curing the dispensed polymer. The another light source may be of a different type than the light source used for at least partly curing the dispensed polymer. For instance, the another light source may be arranged at the another station. The another light source may be arranged perpendicular to the surface of the substrate, i.e. parallel to the normal to the surface of the substrate. The another light source may be arranged with an angle with respect to the surface of the substrate. The angle may be in the range of 0 degees to 180 degrees, preferable in the range of 30 degrees to 150 degrees, with respect to the surface of the substrate.

The one or more components may be electronic components emitting an electric (E) field, i.e. be electrically noisy. The one or more components may be magnetic components emiting an magnetic (M) field, i.e. be magnetically noisy. The one or more components may be electromagnetic components emiting an electromagnetic (EM) field, i.e. be electromagnetically noisy. Further examples of the one or more (noisy/emitting) components may be power components, such as step down converters or switch mode power supplies which comprises a choke, a coil or a capacitor to store energy periodically, resulting in high magnetic and/or electrical noise. Both step down converters and switch mode power supplies may radiate both magnetic and electric fields resulting in electromagnetic fields. Such components may need to be shielded to protect other sensitive components and devices from the electric field, the magnetic field or the electromagnetic field emitted from such components that can otherwise interfere with the sensitive components and devices. Such components may also need to be shielded against other components and devices emitting an electric field, an magnetic field and/or an electromagnetic field.

Components within the hearing device being sensitive to electrical, magnetical and/or electromagnetic noise may be magnetic coils or electromagnetic coils for providing wireless communication with other electronic devices and/or for transmission or reception of radio frequency signals. In a hearing device, there may be a magnetic induction (MI) coil and/or there may be a tele coil. These coils should be electromagnetically (EM) shielded from electromagnetic noisy components within the hearing device.

In some embodiments, the method further comprises applying a conductive material on the at least partly encapsulated component, subsequent to the step of repeating the steps of dispensing, protecting and at least partly curing, to form a magnetic and/or electrical and/or electromagnetic shield. The conductive material may be applied to form a magnetic and/or electrical and/or electromagnetic shield around the one or more components being magnetic and/or electrical and/or electromagnetic noisy . The conductive material may be sprayed on top of the dispensed and/or at least partly cured polymer or may be applied on top of the dispensed and/or at least partly cured polymer by using the same/similar method as to apply the dispensed polymer, i.e. by (repeating the steps of) dispensing, protecting and at least partly curing at least one drop of conductive material. The substrate may be configured to ground such shielding of, i.e. conductive material covering, one or more components being magnetic and/or electrical and/or electromagnetic noisy.

According to a second aspect, disclosed is a system for at least partly encapsulating at least one component arranged on a substrate. The system comprises a nozzle configured to dispense at least one first drop of a polymer on and/or around the component by jetting to obtain a dispensed polymer. The nozzle is arranged above the substrate. The system further comprises a light source configured to at least partly cure the dispensed polymer. The light source is arranged above the substrate. The system further comprises a protection element configured to protect the nozzle. The protection element is arranged at the nozzle.

The system may be configured to at least partly encapsulate the at least one component arranged on the substrate according to the first aspect. The second aspect may generally present the same or corresponding advantages as the first aspect.

The nozzle may be connected to a first container. The first container may be a pump, e.g. a stroke or piezo-electric pump. The first container may be the same or similar to the first container defined in relation to the first aspect. The first container may be connected to a second container. The second container may be the same or similar to the second container defined in relation to the first aspect. The nozzle may be arranged perpendicular to a surface of the substrate comprising the one or more components, i.e. parallel to a normal to the surface of the substrate comprising the one or more components. The nozzle may be arranged with an angle with respect to the surface of the substrate comprising the one or more components. Wherein the nomal to the substrate is 90 degrees with respect to the the surface of the substrate comprising the one or more components, the angle of the nozzle may be in the range of 30 degrees to 150 degrees, with respect to the the surface of the substrate comprising the one or more components.

The light source may be arranged adjacent to the nozzle. The light source may be arranged in a close proximity of the nozzle. The light source may be arranged perpendicular to the surface of the substrate, i.e. parallel to the normal to the surface of the substrate comprising the one or more components. The light source may be arranged with an angle with respect to the surface of the substrate comprising the one or more components. Wherein the nomal of the substrate is 90 degrees to the the surface of the substrate comprising the one or more components, the angle of the light source may be in the range of 0 degress to 180 degress, preferably 30 degrees to 150 degrees, with respect to the the surface of the substrate comprising the one or more components. The light source may be a non-movable light source, i.e. a stationary light source, or it may movable light source. The light source may be an independently movable light source or the light source may be attached to the nozzle and/or configured to move together with the nozzle. An advantage of having a movable light source is that a more uniform (at least partly) curing may be provided, as the angle and/or distance with which the light/rays from the light source is applied to the dispensed polymer may be optimized.

The protection element may be arranged in front of the nozzle. The protection element may be arranged around, such as partly around the nozzle. The protection element may be arranged in a close proximity of the nozzle. The protection element may be arranged in between the nozzle and the light source.

The system may further comprise a controller. The controller may be configured to move the substrate vertically. In other words, the controller may be configured to move the substrate along the normal to the surface of the substrate comprising the one or more components, i.e. closer to the nozzle prior to the step of dispensing. The controller may be configured to move the substrate in a direction opposite to the normal to the surface of the substrate comprising the one or more components, i.e. away from the nozzle prior to the step of at least partly curing. The controller may be configured to move the substrate horizontally. In other words, the controller may be configured to move the substrate in a direction perpendicular to the normal to the surface of the substrate comprising the one or more components. The controller may move the substrate in the direction perpendicular to the normal to the surface of the substrate to align another component arranged on the substrate with the nozzle prior to encapsulating the another component arranged on the substrate.

The controller may be configured to move the nozzle vertically. In other words, the controller may be configured to move the nozzle along the normal to the surface of the substrate comprising the one or more components, i.e. closer to the substrate prior to the step of dispensing. The controller may be configured to move the nozzle in a direction opposite to the normal to the surface of the substrate comprising the one or more components, i.e. away from the substrate prior to the step of at least partly curing. The controller may be configured to move the nozzle horizontally. In other words, the controller may be configured to move the nozzle in a direction perpendicular to the normal to the surface of the substrate comprising the one or more components. The controller may be configured to move the nozzle horizontally prior to and subseqyent to dispensing one drop of poymer. The controller may be configured to move the nozzle horizontally between dispensing a first and a second drop of poymer. The controller may change the angle of the nozzle with respect to the surface of the substrate comprising the one or more components. The angle of the light sourch may be changed within a range of 30 degrees to 150 degrees with respect to the surface of the substrate comprising the one or more components.

The controller may be configured to move the light source vertically. In other words, the controller may be configured to move the light source along the normal to the surface of the substrate comprising the one or more components, i.e. closer to the substrate prior to the step of at least partially curing. The controller may be configured to move the light source in a direction opposite to the normal to the surface of the substrate comprising the one or more components, i.e. away from the substrate subsequent to the step of at least partly curing. The controller may be configured to move the light source horizontally. In other words, the controller may be configured to move the light source in a direction perpendicular to the normal to the surface of the substrate comprising the one or more components. The controller may be configured to change the angle of the light source. The controller may change the angle of the light source with respect to the surface of the substrate comprising the one or more components. The angle of the light sourch may be changed within a range of 0 degrees to 180 degrres, preferably within a range of 30 degrees to 120 degrees, with respect to the surface of the substrate comprising the one or more components.

In some embodiments, the protection element is a shutter. Thereby, the shutter may protect the nozzle and the polymer residues remained in and/or on the nozzle from becoming exposed to the light source in an improved manner, i.e. by means of a faste open/close protection mechanism and in a more efficient manner, wherein the shutter speed may be up to 1/1000, i.e. the shutter may open and close at a rate of up to 1/1000 of a second.

According to a third aspect, disclosed is a hearing device. The hearing device comprises a substrate having at least one partly encapsulated component. The at least one partly encapsulated component is encapsulated according to the method of the first aspect. The third aspect may generally present the same or corresponding advantages as the first and the second aspect. In addition, the third aspect allows for providing an improved hearing device by providing an improved encapsulation of components of the hearing device being sensitive to environmental factor, such as humidity, heat, cold, dust, sand, a emitted electric field, a emitted magnetic field, a emitted electromagnetic field, etc, and/or providing an improved encapsulation of components of the hearing device emitting a electric field, a magnetic field or a electromagnetic field.

The present invention relates to different aspects including the method, the system and the hearing device described above and in the following, and corresponding method steps and system parts, each yielding one or more of the benefits and advantages described in connection with the first mentioned aspect, and each having one or more embodiments corresponding to the embodiments described in connection with the first mentioned aspect and/or disclosed in the appended claims.

### BRIEF DESCRIPTION OF THE DRAWINGS

The above and other features and advantages will become readily apparent to those skilled in the art by the following detailed description of exemplary embodiments thereof with reference to the attached drawings, in which:
Fig. 1 schematically illustrates a method 100 of at least partly encapsulating at least one component 2 arranged on a substrate 4.
Fig. 2 schematically illustrates a system 300 for at least partly encapsulating at least one component 2 arranged on a substrate 4 during a step of dispensing 110.
Fig. 3 schematically illustrates the system 300 for at least partly encapsulating the at least one component 2 arranged on the substrate 4 (shown in Fig. 2) during a step of at least partly curing 130.
Fig. 4a schematically illustrates an exemplary cross-sectional view of a substrate 4 comprising a plurality of components 2.
Fig. 4b schematically illustrates the exemplary cross-sectional view of the substrate 4 comprising the plurality of components 2 shown in Fig. 4a, subsequent to encapsulating the components 2.
Fig. 5a schematically illustrates an exemplary top view of a substrate 4 comprising a plurality of components 2 prior to encapsulating the components.
Fig. 5b-c schematically illustrates an exemplary top view of a substrate 4 comprising a plurality of components 2 (shown in Fig. 5a) during encapsulating the components 2.
Fig. 5d schematically illustrates an exemplary top view of a substrate 4 comprising a plurality of components 2 (shown in Fig. 5a) subsequent to encapsulating the components 2.
Fig. 6 schematically illustrates an example of a hearing device 20.
Figs. 7 and 8 schematically illustrate an example of a block-diagram of an embodiment of a hearing device 200.
Fig. 9 schematically illustrate an example of a method of dispensing 110, protecting 120 and at least partly curing 130, thereby at least partly encapsulating at least one component 2.
Fig. 10 schematically illustrate another example of a method of dispensing 110, protecting 120 and at least partly curing 130, thereby at least partly encapsulating at least one component 2

### DETAILED DESCRIPTION

Various embodiments are described hereinafter with reference to the figures. Like reference numerals refer to like elements throughout. Like elements will, thus, not be described in detail with respect to the description of each figure. It should also be noted that the figures are only intended to facilitate the description of the embodiments. They are not intended as an exhaustive description of the claimed invention or as a limitation on the scope of the claimed invention. In addition, an illustrated embodiment needs not have all the aspects or advantages shown. An aspect or an advantage described in conjunction with a particular embodiment is not necessarily limited to that embodiment and can be practiced in any other embodiments even if not so illustrated, or if not so explicitly described.

Throughout, the same reference numerals are used for identical or corresponding parts.

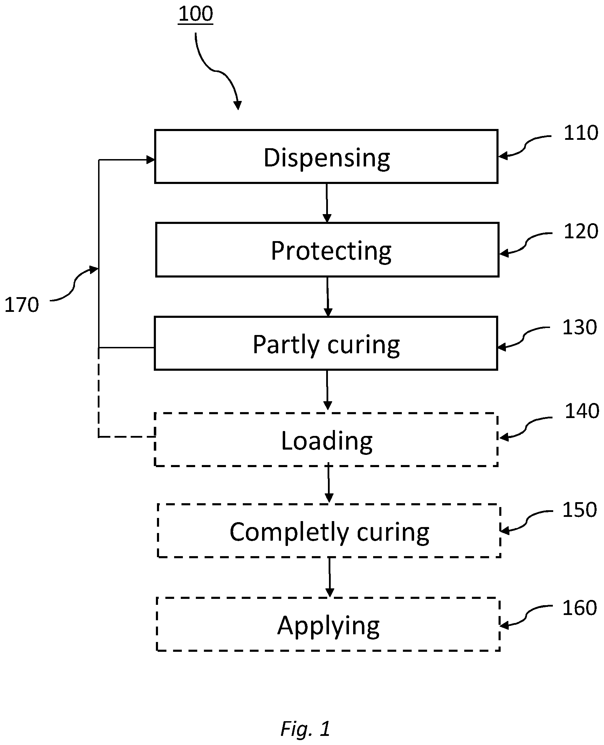

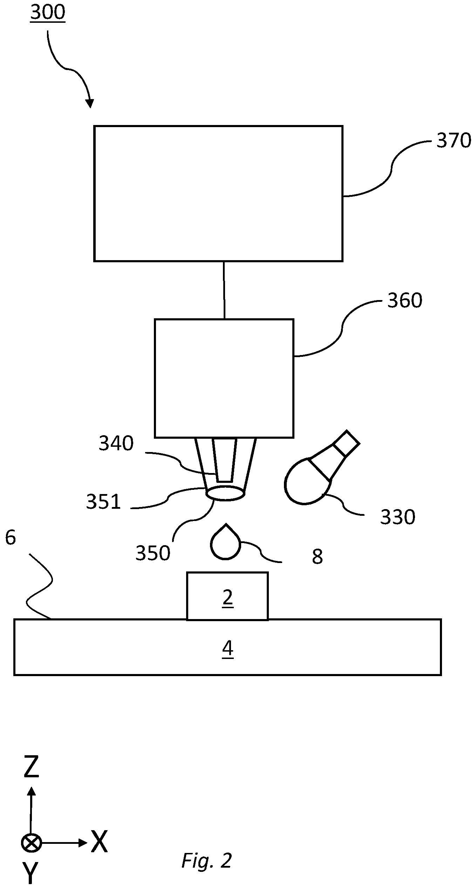

Fig. 1 schematically illustrates a method 100 of at least partly encapsulating at least one component 2 arranged on a substrate 4, see Fig. 2. The method 100 comprises the step of dispensing 110 at least one drop of a polymer 8 on and/or around and/or under the component(s) 2 by jetting. The at least one drop of the polymer 8 may be an at least one first or second or third, etc., drop of the polymer 8. The at least one drop of the polymer 8 may be up to 10,000 drops of the polymer 8. The step of dispensing 110 is performed using a nozzle 340, to obtain a dispensed polymer 8. The method further comprises the step of at least partly curing 130 the dispensed polymer 8 by exposing the dispensed polymer 8 to a light source 330 to obtain a cured polymer 8. The method 100 further comprises the step of protecting 120 the nozzle 340 while at least partly curing 130 the dispensed polymer 8. The method further comprises the step of repeating 170 the steps of dispensing 110, protecting 120 and at least partly curing 130, thereby at least partly encapsulating the component(s) 2. The method 100 may further comprise the step of loading 140 the polymer 8 into the nozzle 340 for a next drop of the polymer, such as at least one next drop of the polymer, while at least partly curing 130 the dispensed polymer 8 and/or after dispensing the one first drop of the polymer 8 and/or between dispensing 110 the one first drop of polymer 8 and one next drop of polymer 8. The at least one next drop of the polymer 8 may be an at least one second or third or fourth, etc, drop of the polymer 8. The step of repeating 170 may thus comprise the steps of dispensing 110, protecting 120, at least partly curing 130 and loading 140, thereby at least partly encapsulating the component(s) 2.

The step of at least partly curing 130 the dispensed polymer 8 may comprise a step of activating/turn on and subsequently deactivate/turn off a light source 330 configured for at least partly curing 130 the dispensed polymer 8 to obtain an at least partly cured polymer 8 while the nozzle 340 is protected from the light source 360 by a protection element 350.

The step of protecting 120 the nozzle 340 while at least partly curing 130 the dispensed polymer 8 may comprise the steps of activating a protection element 350 to go into a protective state/mode/position configured for protecting 120 the nozzle 340 from the light source 330 before the light source 330 configured to at least partly curing 130 the dispensed polymer 8 to obtain a cured polymer 8 is activated/turned on. The step of protecting 120 the nozzle 340 while at least partly curing 130 the dispensed polymer 8 may further comprise a step of activating the protection element 350 to go into a non-protective state/mode/position not protecting 120 the nozzle 340 from the light source after the light source 330 configured for at least partly curing 130 the dispensed polymer 8 to obtain a cured polymer 8 is deactivated/turned off.

Fig. 1 shows that the method 100 further may comprise the step of completely curing 150 the at least partly encapsulated component(s) 2 subsequent to the step of repeating 170 the steps of dispensing 110, protecting 120 and at least partly curing 130, when the at least one component is at least partly encapsulated. The method 100 may further comprise the step of applying 160 a conductive material on the at least partly encapsulated component(s) 2, subsequent to the step of repeating 170 the steps of dispensing 110, protecting 120 and at least partly curing 130. The step of applying 160 a conductive material on the at least partly encapsulated component(s) 2 may comprise spraying the conductive material on top of the dispensed and/or at least partly cured polymer. The step of applying 160 a conductive material on the at least partly encapsulated component(s) 2 may comprise (repeating steps of) dispensing, protecting and at least partly curing at least one drop of conductive material by using the same or similar method and/or system as when (repeating steps of) dispensing, protecting and at least partly curing the at least one drop of polymer.

By encapsulating the components 2 with the polymer 8 solid particles (like dirt and dust) and moisture is prevented from reaching/damading/corroding the components 2.

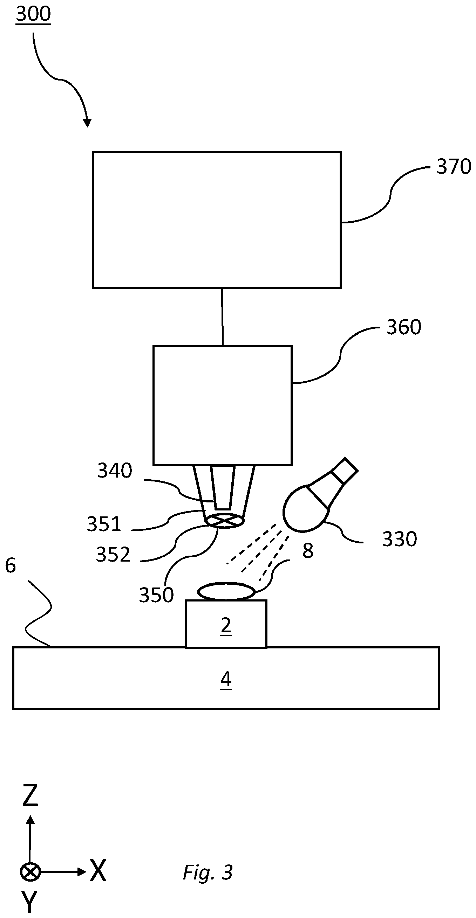

The step of applying 160 a conductive material on the at least partly encapsulated component(s) 2 may form a shield around the one or more component(s), such as a shield preventing electrical and/or magnetic and/or electromagnetic noice from the one or more component(s) to reach other components within the hearing device being sensitive to such noise. The method 100, shown in Fig. 1 may be performed using the system 300 shown in Figs. 2 and 3, described below.

Fig. 2 schematically illustrates a system 300 for at least partly encapsulating at least one component 2 arranged on a substrate 4. The system 300, shown in Fig. 2, comprises a nozzle 340. The nozzle 340 is configured to dispense 110 at least one drop of a polymer 8 on and/or around the component(s) 2 by jetting. The nozzle 340 is arranged above the substrate 4. The system 300 further comprises a light source 330. The light source 330 is configured to at least partly cure 130 the dispensed polymer 8. The light source 330 is arranged above the substrate 4. The system 300 further comprises a protection element 350. The protection element 350 is configured to protect 140 the nozzle 340. The protection element 350 is arranged at the nozzle 340. In the illustrated embodiment, the protection element 350 comprises a shield 351 surrounding the sides of the nozzle 340 and four movable shutter plates 352 shown in Fig. 3. The shutter plates are configured to cover an opening in the shield 351, wherein the opening in the shield is aligned with the tip/opening of the nozzle wherethrough the polymer is dispensed. The shield 351 may be an UV impenetrable shield and/or and the shutter plates 352 may be UV impenetrable shutter plates.

Fig. 2 schematically illustrates the system 300 during a step of dispensing 110 the at least one drop of the polymer 8 on the component 2 by jetting. The step of dispensing 110 may comprise jetting the at least one drop of a UV-curable polymer 8 on and/or around the component 2. The polymer 8 may comprise acrylated (poly)urethane, for example Humiseal UV40 polymer. Fig. 2 shows that the protection element 350 is in a non-protective state, such as open.

The system 300 may further comprise a first container 360. The nozzle 340 may be connected to the first container 360. The first container 360 may be a pump, e.g. a stroke or a piezo-electric pump. The first container 360 may be a syringe. The first container 360 may be connected to a second container 370. The second container 370 may also be a pump, e.g. a stroke or a piezo-electric pump. The second container 370 may be a cartridge. The polymer material may be loaded to the second container 370. The first container 360 may be arranged downstream the second container 370 such that the polymer material may flow/be pumped from the second container 370 into the first container 360. The nozzle 340 may be arranged downstream the first 360 container such that the polymer material may flow/be pumped from the first container 360 into the nozzle 340 for a next step of dispensing.

The system 300 may further comprise a controller. The controller may be configured to move the nozzle 304 in a direction opposite to a normal to a surface 6 of the substrate 4 comprising the component 2. The controller may be configured to move the nozzle 340 along a Z direction shown in Fig. 2, i.e. closer to the substrate 340. The controller may be configured to change the angle of the nozzel 340 with respect to the the surface 6 of the substrate 4 comprising the component 2. The controller may be configured to change the angle of the nozzel 340 between 30 degrees to 150 degrees with respect to the the surface 6 of the substrate 4 comprising the component 2. The controller may move the nozzle 340 closer to the substrate 4 and/or change the angle of the nozzle 340 prior to the step of dispensing 110. Alternatively, the controller may be configured to move the substrate 4 in a direction along the normal to the surface 6 of the substrate 4 comprising the component 2. The controller may be configured to move the substrate 4 along the Z direction shown in Fig. 2, i.e. closer to the nozzle 340. The controller may move the substrate 4 closer to the nozzle 340 prior to the step of dispensing 110.

Fig. 3 schematically illustrates the system 300 shown in Fig. 2 during a step of at least partly curing 130 the dispensed polymer 8. Fig. 3 shows that the dispensed polymer 8 is exposed to a light source 330. The light source 330 may be a movable or non-movable light source. Fig. 3 further shows that the protection element 350 is in a protective state, such as closed. The controller may be configured to move the nozzle 340 in a direction opposite to the normal to the surface 6 of the substrate 4 comprising the component 2. The controller may be configured to move the nozzle 340 along the Z direction shown in Fig. 2, i.e. away from the substraye 4 prior to the step of at least partly curing 130. Alternatively, the controller may be configured to move the substrate 4 in the direction opposite to the normal to the surface 6 of the substrate 4 comprising the component 2. The controller may be configured to move the substrate 4 along the Z direction shown in Fig. 2, i.e. away from the nozzle 340 prior to the step of at least partly curing 130. The controller may be configured to move the light source 330 in a direction along the X, Y and/or Z direction towards the dispensed material prior to or during the step of at least partly curing 130 the dispensed polymer 8. The controller may be configured to change the angle of the light source 330 between 0 degrees to 180 degrees, preferably between 30 degrees to 100 degrees, with respect to the the surface 6 of the substrate 4 comprising the component 2. The controller may be configured to change the angle of the light source 330 prior to or during the step of at least partly curing 130 the dispensed polymer 8.

The controller may move the substrate along a X and/or Y direction shown in Fig. 2 and 3 to align another component 2 arranged on the substrate 4 with the nozzle 340 prior to encapsulating the another component 2 arranged on the substrate 4. The substrate 4 may be arranged on a conveyor belt which move the substrate in the X direction shown in Fig. 2 and 3 prior to encapsulating the another component 2 arranged on the substrate 4. The controller may move the nozzle 340 in the X and/or Y direction shown in Fig. 2 and 3 prior to encapsulating the another component 2 arranged on the substrate 4. The controller may move the light source 330 together with the nozzle 340 in the X and/or Y direction shown in Fig. 2 and 3 prior to encapsulating the another component 2 arranged on the substrate 4.

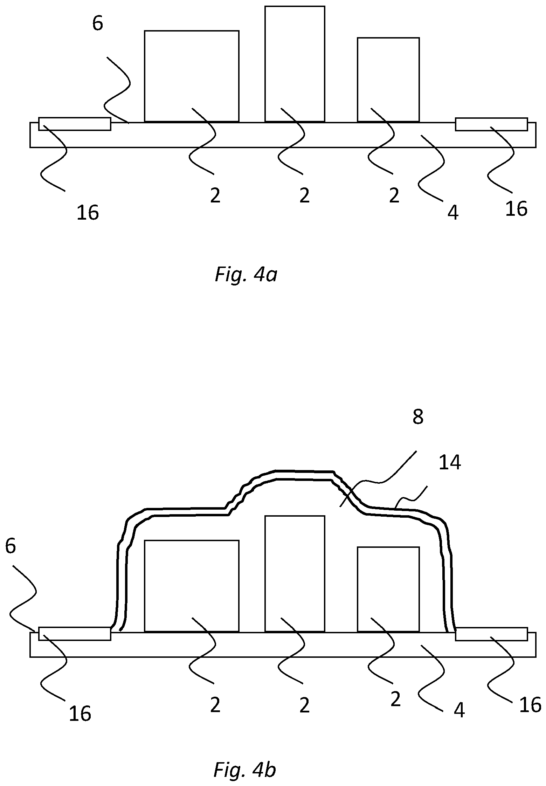

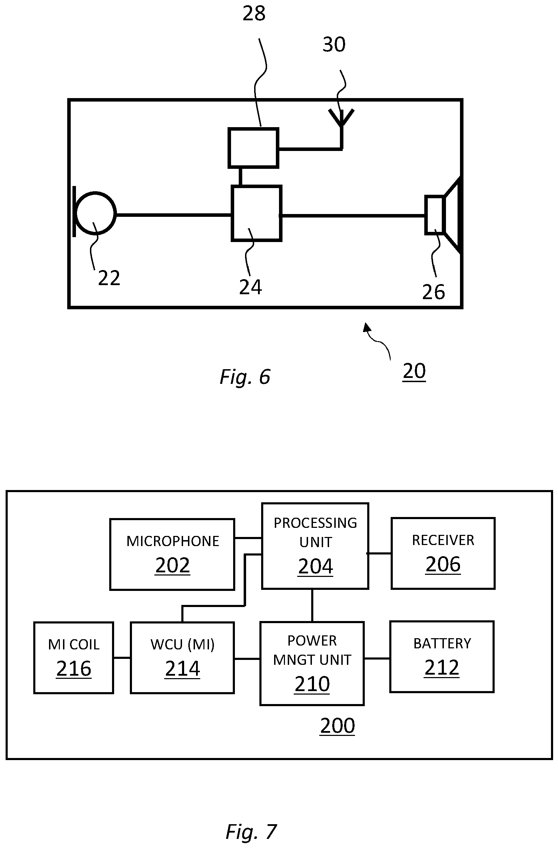

Fig. 4a schematically illustrates an exemplary cross-sectional view of a substrate 4 comprising a plurality of components 2. The substrate 4 may be any substrate such as a PCB or a PCBA. The substrate 4 may be a substrate of a hearing device 20, 200, see Figs. 6, 7 and 8. The component 2 may comprise any electronic component, any magnetic component or any electromagnetic component. The components 2 may be components 2 of a hearing device 20, 200. The components 2 may be arranged or placed on and/or attached to a surface 6 of the substrate 4. The components 2 may be different components or the same components. The electronic components may have different sizes and shapes, such as different heights, different base areas, different volumes etc. The substrate 4 may additionally comprise a ground ring or ground plane 16.

Fig. 4b schematically illustrates the exemplary cross-sectional view of the substrate 4 comprising the plurality of components 2 shown in Fig. 4a, subsequent to encapsulating the components 2 with a polymer 8. Fig. 4b shows that the components 2 are completely encapsulated by a layer of dipensed polymer 8 and that the components additionally, such as on top of the layer of the dispensed and at least partially cured polymer 8, may be encapsulated by a layer of conductive material 14. The conductive material 14 may be connected to the ground ring or ground plane 16. By encapsulating the components 2 with the polymer 8 the conductive material 14 is prevented from reaching/damading/corroding the components 2. By encapsulating the components 2 with the conductive material 14 noise from the components 2 may be shielded from reaching other components within the hearing device, such as other components on the substrate 4, such as antennas within the hearing device. The components 2 may alternatively be partly encapsulated.

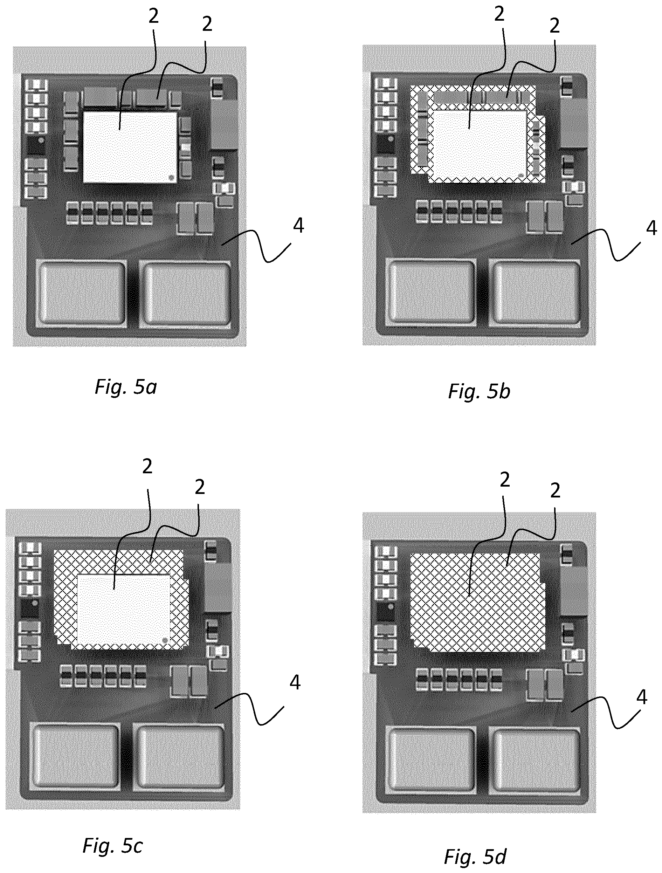

Figs. 5a-d schematically illustrate an example of a substrate 4 comprising a plurality of components 2 and a method of at least partly encapsulating at least one component 2 arranged on the substrate 4. In Figs. 5a-d, the substrate 4 is seen from above, in a top view. Fig. 5a schematically illustrates an exemplary top view of a substrate 4 prior to encapsulating the components. The substrate 4 may be a substrate of a hearing device 20, 200, see Figs. 6, 7 and 8. Fig. 5b-c schematically illustrate the exemplary top view of a substrate 4, shown in Fig. 5a, during encapsulating the components 2. Fig. 5b shows that the components 2 are at least partly encapsulated. Fig. 5b further shows that areas around the components 2 are at least partly encapsulated. Fig. 5c shows that some of the components 2 are completely encapsulated. Fig. 5d shows that all the components 2 are completely encapsulated.

Fig. 6 schematically illustrates an example of a hearing device 20, such as a hearing aid. The hearing device 20 comprises an input transucer, i.e. a microphone 22, for receiving an acoustic signal and converting it into a first electric input signal. The first electric input signal is provided to a processing unit 24 for processing the first electric input signal and providing a second electric output signal. The second electric output signal may compensate for a hearing loss of a user of the hearing device 20. An output transducer, i.e. a receiver 26, is connected to an output of the processing unit 24 for converting the second electric output signal into an acoustic output signal, e.g. an acoustic output signal modified to compensate for a user's hearing impairment. The processing unit 24 may comprise elements such as amplifiers, compressors, noise reduction systems, etc. The hearing device 20 may further comprise a wireless communication unit 28 for wireless data communication interconnected with an antenna 30 for emission and reception of an electromagnetic field. The wireless communication unit 28, such as a radio or a transceiver, connects to the processing unit 24 and the antenna 30, for communicating with an electronic device, an external device, or with another hearing device, such as another hearing aid located in/on/at another ear of the user, typically in a binaural hearing system. The hearing device 20 may comprise two or more antennas.

The hearing device 20 may be a behind-the-ear hearing device, and may be provided as a behind-the-ear unit. The hearing device 20 may be an in-the-ear hearing device and may be provided as an in-the-ear unit. Alternatively, parts of the hearing device 20 may be provided in a behind-the-ear unit, while other parts, such as the receiver 26, may be provided in an in-the-ear unit.

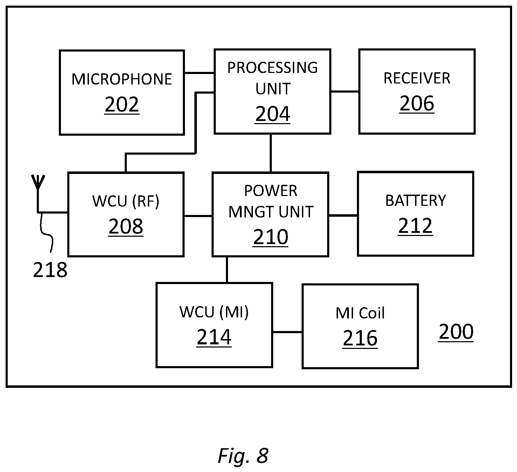

Figs. 7 and 8 schematically illustrate an example of a block-diagram of an embodiment of a hearing device 200. In Fig. 7, the hearing device 200 comprises a first input transducer, i.e. a microphone 202, to generate one or more first electric input signals based on a received acoustic signal. The one or more first electric input signals are provided to a processing unit 204 for processing the one or more first electric input signals. An output transducer, i.e. a receiver 206, is connected to an output of the processing unit 204 for converting the output i.e. a second electric output signal of the processing unit into an acoustic output signal, wherein the acoustic output signal may be modified to compensate for a user's hearing impairment.

The processing unit 204 may comprise elements such as an amplifier, a compressor and/or a noise reduction system etc. The processing unit 204 may be implemented in a signal-processing chip. The hearing device may further have a filter function, such as compensation filter for optimizing the acostic output signal.

The hearing device further comprises a wireless communication unit 214 interconnected with magnetic antenna 216 such as a magnetic induction coil. The wireless communication unit 214 and the magnetic antenna 216 may be configured for wireless data communication using emission and reception of a magnetic field. The wireless communication unit may be implemented as a wireless communication chip, such as a magnetic induction control chip. The magnetic antenna may be configured for communication with another electronic device, in some embodiments it is configured for communication with another hearing device, such as another hearing device located at/on/in another ear of the user, typically in a binaural hearing device system. The magnetic antenna may be configured for wireless power transfer, such as inductive charging, i.e. receiving power from another electronic device, such as a charging device.

The hearing device may furthermore have a wireless communication unit 208, such as a wireless communication circuit, for wireless data communication interconnected with an electric antenna 218, such as a RF antenna for emission and reception of an electromagnetic field. The wireless communication unit may be implemented as a wireless communication chip. The wireless communication unit 208, including a radio or a transceiver, connect to the hearing device processing unit 204 and the electric antenna 218, for communicating with one or more external devices, such as one or more external electronic devices, including at least one smart phone, at least one tablet, at least one hearing accessory device, including at least one spouse microphone, remote control, audio testing device, etc., or, in some embodiments, with another hearing device, such as another hearing device located at another ear, typically in a binaural hearing device system.

The hearing device 200 further comprises a power source 212, such as a battery or a rechargeable battery. Furthermore, a power management unit 210 is provided for controlling the power provided from the battery 212 to the processing unit 204, the receiver 206, the one or more microphones 202, the wireless communication unit (RF) 208, and the wireless communication unit (MI) 214.

The processing unit 204, the wireless communication unit (RF) 208, the wireless communication unit (MI) 214 and the power management unit 210 may be implemented as a signal-processing chip, wireless communication chip (RF), wireless communication chip (Ml) and power management chip, respectively.

In Fig. 8, a hearing device corresponding to the hearing device as shown in Fig. 7 is seen, except that in Fig. 7, only one wireless communication unit 214 is present being interconnected with the magnetic antenna 216, the processing unit 204 and the power management unit 210.

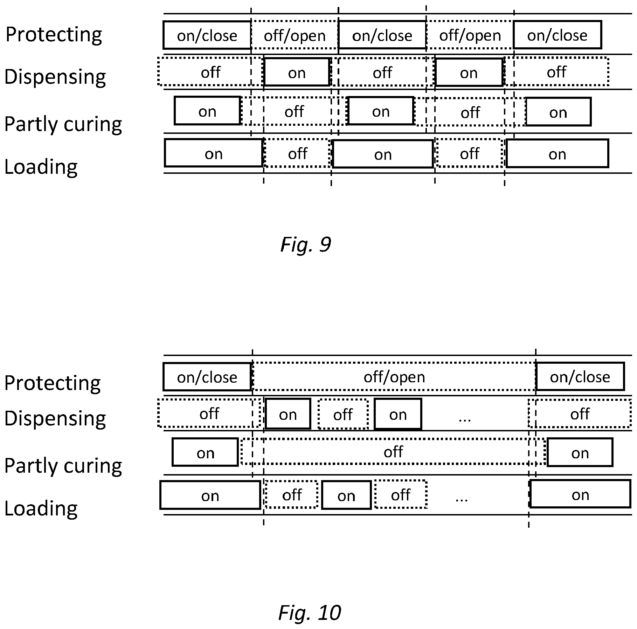

Fig. 9 schematically illustrate an example of a method of dispensing 110, protecting 120 and at least partly curing 130, thereby at least partly encapsulating at least one component 2. In the illustrated example the step of dispensing 110 comprises dispensing one drop of polymer, protecting 120 the nozzle, at least partly curring 130 the one drop of polymer and optionally loading 140 the nozzle with a next drop of polymer after having dispensed the one drop of polymer and before dispensing 110 the next drop of polymer. The steps may be repeated 170 until one or more component(s) 2 is/are completely or at least partly encapsulated.

The protection element may be deactivated/turned off/opened, shortly before the nozzle start dispensing. The protection element may be activated/turned on/closed, shortly after the nozzle finish dispensing. The light source may be turned on shortly after the protection element is activated/turned on/closed. The light source may be turned off shortly before the protection element is deactivated/turned off/opened. The nozzle may be loading a next drop of polymer any time between dispensing the one drop of polymer and the next drop of polymer. Alternatively, the nozzle may be loading a next drop of polymer at the same time as dispensing the one drop of polymer.

Fig. 10 schematically illustrate another example of a method of dispensing 110, protecting 120 and at least partly curing 130, thereby at least partly encapsulating at least one component 2. In the illustrated example the step of dispensing 110 comprises dispensing two or more drops of polymer, optionally loading 140 the nozzle with a next drop of polymer in between each dispensed drop of polymer, and protecting 120 the nozzle and at least partly curring 130 the dispensed drops of polymer after having dispensed the two or more drops of polymer and before optionally dispensing 110 additionally two or more drops of polymer. The steps are repeated 170 until one or more component(s) 2 is/are completely or at least partly encapsulated.

The protection element may be deactivated/turned off/opened, shortly before the nozzle start dispensing the two or more drops of polymer. The protection element may be activated/turned on/closed, shortly after the nozzle finish dispensing the two or more drops of polymer. The light source may be turned on shortly after the protection element is activated/turned on/closed. The light source may be turned off shortly before the protection element is deactivated/turned of/opened. The nozzle may be loading a next drop of polymer any time between dispensing the one drop of polymer and the next drop of polymer of the two or more drops of polymer and/or between dispensing two or more drops of polymer and aditionally two or more drops of ploymer. Alternatively, the nozzle may be loading a next drop of polymer at the same time as dispensing one drop of the two or more drops of polymer and/or dispensing two or more drops of polymer.

Although particular features have been shown and described, it will be understood that they are not intended to limit the claimed invention, and it will be made obvious to those skilled in the art that various changes and modifications may be made without departing from the scope of the claimed invention. The specification and drawings are, accordingly to be regarded in an illustrative rather than restrictive sense. The claimed invention is intended to cover all alternatives, modifications and equivalents.

### LIST OF REFERENCES

2 components
4 substrate
6 surface of substrate
8 polymer
14 conductive material
16 ground ring or ground plane
20 hearing device
22 input transducer microphone
24 processing unit
26 output transducer receiver
28 wireless communication unit
30 antenna
200 hearing device
202 first transducer, e.g. microphone
204 processing unit
206 acoustic output transducer
208 wireless communication unit (RF)
210 power management unit
212 power source
214 wireless communication unit (Ml)
216 magnetic antenna
218 electric antenna
100 method
110 dispensing
120 protecting
130 partly curing
140 loading
150 completely curing
160 applying
170 repeating
300 system
330 light source
340 nozzle
350 protection element
351 shield
352 shutter plate(s)
360 first container
370 second container

## Claims

1. A method (100) of at least partly encapsulating at least one component (2) arranged on a substrate (4), the method (100) comprising the steps of:
- dispensing (110) at least one first drop of a polymer (8) on and/or around the component (2) by jetting, using a nozzle (340), to obtain a dispensed polymer (8),
- at least partly curing (130) the dispensed polymer (8) by exposing the dispensed polymer (8) to a light source (330) to obtain a cured polymer (8),
- protecting (120) the nozzle (340) while at least partly curing (130) the dispensed polymer (8), and
- repeating (170) the steps of dispensing (110), protecting (120) and at least partly curing (130), thereby at least partly encapsulating the at least one component (2).

2. The method (100) according to claim 1, wherein the step of dispensing (110) comprises dispensing (110) the at least one first drop of the polymer (8) on and/or around at least a side of the component (2).

3. The method (100) according to claim 1 or 2, wherein the step of dispensing (110) comprises jetting the at least one first drop of a UV-curable polymer (8) on and/or around the component (2).

4. The method (100) according to claim 3, wherein the step of at least partly curing (130) comprises at least partly curing (130) the dispensed polymer (8) by exposing the dispensed polymer (8) to a UV light source (330) to obtain a cured polymer (8).

5. The method (100) according to claim 4, wherein the step of at least partly curing (130) comprises exposing the dispensed polymer to the UV light source (330) until a surface of the dispensed polymer (8) becomes at least partly cured.

6. The method (100) according to any of the preceding claims, wherein the step of dispensing (110) comprises jetting the at least one first drop of the polymer (8) at a first frequency in the range of 1 Hz to 1000 Hz.

7. The method (100) according to any of the preceding claims, wherein the step of protecting (120) comprises protecting (120) the nozzle (340) from light by means of a protection element (350) while at least partly curing (130) the dispensed polymer (8).

8. The method (100) according to any of the preceding claims, the method (100) further comprising:
- loading (140) the polymer (8) into the nozzle (340) for at least a second drop of the polymer while at least partly curing (130) the dispensed polymer (8) and/or after dispensing the at least one first drop of the polymer (8).

9. The method (100) according to any of the preceding claims, the method (100) further comprising:
- completely curing (150) the at least partly encapsulated component (2) subsequent to the step of repeating (170) the steps of dispensing (110), at least partly curing (130) and protecting (120), when the at least one component is at least partly encapsulated.

10. The method (100) according to any of the preceding claims, the method (100) further comprising:
- applying (160) a conductive material (14) on the at least partly encapsulated component (2), subsequent to the step of repeating (170), the steps of dispensing (110), at least partly curing (130) and protecting (120), to form a magnetic and/or electrical and/or electromagnetic shield.

11. A system (300) for at least partly encapsulating at least one component (2) arranged on a substrate (4), the system (300) comprising:
- a nozzle (340) configured to dispense (110) at least one first drop of a polymer (8) on and/or around the component (2) by jetting to obtain a dispensed polymer (8), the nozzle (340) being arranged above the substrate (4), and
- a light source (330) configured to at least partly cure (130) the dispensed polymer (8), the light source (330) being arranged above the substrate (4), and
- a protection element (350) configured to protect (140) the nozzle (340), the protection element (350) being arranged at the nozzle (340).

12. The system (300) according to claim 11, wherein the protection element (350) is a shutter.

13. A hearing device comprising a substrate having at least one partly encapsulated component, wherein the at least one partly encapsulated component is encapsulated according to the method of any of the claims 1-10.
